# EUROPEAN PATENT APPLICATION

(11) **EP 4 576 202 A1**
(43) Date of publication of application: **25.06.2025**
(21) Application number: 24193927.1
(22) Date of filing: 09.08.2024
(51) Int. Cl.: H01L 23/482, H10D 30/47

(54) **SEMICONDUCTOR DEVICE**

(30) Priority: 18.12.2023 KR 20230184500
(71) Applicant: SAMSUNG ELECTRONICS CO., LTD., Yeongtong-gu Suwon-si, Gyeonggi-do 16677 (KR)
(72) Inventor: LEE, Jung-Wook, Suwon-si (KR); KIM, Jongseob, Suwon-si (KR); KIM, Joonyong, Suwon-si (KR); PARK, Junhyuk, Suwon-si (KR); YANG, Seong Seok, Suwon-si (KR); HWANG, In Jun, Suwon-si (KR)
(74) Representative: Marks & Clerk LLP

(57) **Abstract**

A semiconductor device includes a channel layer; a barrier layer disposed on the channel layer, and including a material with an energy band gap different from that of the channel layer; a gate electrode disposed above the barrier layer, and extending in a first direction; a gate semiconductor layer disposed between the barrier layer and the gate electrode; a source electrode and a drain electrode, respectively disposed on opposite sides of the gate electrode in a second direction intersecting the first direction, each extending in the first direction and connected to the channel layer; a source bus line disposed on the source electrode and the drain electrode, and connected to the source electrode; and a drain bus line spaced apart from the source bus line, wherein each of the source bus line and the drain bus line includes a body portion extending in the second direction, and a plurality of protrusion parts protruding from the body portion in the first direction, each having a width reduced as the protrusion part is further away from the body portion.

## Description

### BACKGROUND

### 1. Field

The disclosure relates to a semiconductor device.

### 2. Description of the Related Art

In modern society, semiconductor devices are closely related to daily life. In particular, the importance of power semiconductor devices has been gradually increased. A power semiconductor device may be used in various fields such as a transportation field such as an electric vehicle, a railway, or an electric tram, a renewable energy system such as solar power generation or wind power generation, or a mobile device. A power semiconductor device may be a semiconductor device used to handle a high voltage or a high current, and to perform functions such as the power conversion and control of a large power system or those of a high-output electronic device. The power semiconductor device may have the ability and durability to handle high power to thus handle large amounts of current and withstand the high voltage. For example, a power semiconductor device may handle voltages from hundreds to thousands of volts and currents from tens to thousands of amperes. A power semiconductor device may have an improved efficiency of electrical energy by minimizing its power loss. In addition, a power semiconductor device may be stably operated even in an environment such as a high temperature.

Power semiconductor devices may be classified based on their materials, and classified into, for example, a silicon carbide (SiC) power semiconductor device and a gallium nitride (GaN) power semiconductor device. A power semiconductor device may be manufactured using silicon carbide (SiC) or gallium nitride (GaN) instead of an existing silicon (Si) wafer, thus compensating for a disadvantage of silicon which is unstable at high temperatures. A SiC power semiconductor device may withstand high temperature, have a lower power loss, and be suitable for electric vehicles, a renewable energy system, or the like. Although a high cost may be required, a GaN power semiconductor device may have an efficient speed and be suitable for high-speed charging of mobile devices.

### SUMMARY

The disclosure describes a semiconductor device, such as a power semiconductor device, with a stable electrical feature and improved reliability.

According to an embodiment, a semiconductor device includes a channel layer; a barrier layer disposed on the channel layer, and including a material with an energy band gap different from that of the channel layer; a gate electrode disposed above the barrier layer, and extending in a first direction; a gate semiconductor layer disposed between the barrier layer and the gate electrode; a source electrode and a drain electrode, respectively disposed on opposite sides of the gate electrode in a second direction intersecting the first direction, each extending in the first direction and connected to the channel layer; a source bus line disposed on the source electrode and the drain electrode, and connected to the source electrode; and a drain bus line spaced apart from the source bus line, wherein each of the source bus line and the drain bus line includes a body portion extending in the second direction, and a plurality of protrusion parts protruding from the body portion in the first direction, each having a width reduced as the protrusion part is further away from the body portion.

According to an embodiment, a semiconductor device includes: a channel layer; a barrier layer disposed on the channel layer, and including a material with an energy band gap different from that of the channel layer; a gate electrode disposed above the barrier layer, and extending in a first direction; a gate semiconductor layer disposed between the barrier layer and the gate electrode; a source electrode and a drain electrode, disposed on opposite sides of the gate electrode in a second direction interesecting the first direction, each extending in the first direction and connected to the channel layer; a source bus line disposed on the source electrode and the drain electrode, and connected to the source electrode; and a drain bus line spaced apart from the source bus line, wherein each of the source bus line and the drain bus line includes a bod portion extending in the second direction, and a plurality of protruding extension portions protruding from the body portion in the first direction, wherein each protruding extension portion of the plurality of protruding extension portions of the source bus line has a convex edge, and each protruding extension portion of the plurality of protruding extension portions of the drain bus line has a convex edge.

According to an embodiment, a semiconductor device includes: a channel layer; a barrier layer disposed on the channel layer, and including a material with an energy band gap different from that of the channel layer; a gate electrode disposed above the barrier layer, and extending in a first direction; a gate semiconductor layer disposed between the barrier layer and the gate electrode; a source electrode and a drain electrode, disposed on opposite sides of the gate electrode, extending in the first direction, and connected to the channel layer; a source bus line disposed on the source electrode and the drain electrode, and connected to the source electrode; a drain bus line spaced apart from the source bus line; and a source bonding connector in contact with an upper surface of the source bus line, wherein each of the source bus line and the drain bus line includes a main wire part extending in a second direction intersecting the first direction, and a protrusion part protruding from the main wire part in the first direction, and the source bonding connector overlaps the protrusion part of the source bus line in the first direction.

According to the embodiments, a semiconductor device may have improved electrical features and reliability.

At least some of the above and other features of the invention are set out in the claims.

### BRIEF DESCRIPTION OF THE DRAWINGS

FIG. 1 is a plan view showing a semiconductor device according to an embodiment.
FIG. 2 is a plan view showing some layers of the semiconductor device according to an embodiment.
FIG. 3 is a cross-sectional view taken along line III-III' of FIG. 1.
FIG. 4 is a cross-sectional view taken along line IV-IV' of FIG. 1.
FIG. 5 is a cross-sectional view taken along line V-V' of FIG. 1.
FIG. 6 is a cross-sectional view taken along line VI-VI' of FIG. 1.
FIG. 7 is a plan view showing a semiconductor device according to an embodiment.
FIG. 8 is a cross-sectional view taken along line VIII-VIII' of FIG. 7.
FIGS. 9 and 10 are plan views each showing a semiconductor device according to an embodiment.
FIGS. 11 to 15 are plan views showing a semiconductor device according to an embodiment.

### DETAILED DESCRIPTION OF THE EMBODIMENTS

Hereinafter, embodiments of the disclosure are described in detail with reference to the accompanying drawings for those skilled in the art to which the disclosure pertains to easily practice the invention. The disclosure may be modified in various different forms, and is not limited to the embodiments provided in the specification.

The same or similar components may be denoted by the same reference numeral throughout the specification.

In addition, the size and thickness of each component shown in the accompanying drawings are arbitrarily shown for convenience of explanation, and therefore, the disclosure is not necessarily limited to contents shown in the drawings. The thicknesses are exaggerated in the drawings in order to clearly represent several layers and regions. In addition, the thicknesses of some layers and regions are exaggerated in the drawings for convenience of explanation.

In addition, when an element such as a layer, a film, a region or a plate is referred to as being "on" or "above" another element, the element may be "directly on" another element or may have a third element interposed therebetween. On the other hand, when an element is referred to as being "directly on" another element, there is no third element interposed therebetween. The term "contact," "contacting," "contacts," or "in contact with," as used herein, refers to a direct connection (i.e., touching) unless the context clearly indicates otherwise. In addition, when an element is referred to as being "on" or "above" a reference element, the element may be disposed on or below the reference element, and may not necessarily be "on" or "above" the reference element in an opposite direction of gravity. The directions and positions described herein are relative to the structure of the device, and therefore need not indicate any particular orientation of the device in use. For instance, a height direction may be defined (e.g. perpendicular to a substrate of the device) and an element that is "above" a reference element may be located further along the height direction than the reference element.

In addition, throughout the specification, when a component "includes" a particular element, it is to be understood that the element by itself may form the component, or the element may be combined with additional elements to form the component, unless the context clearly and/or explicitly describes the contrary.

Further, throughout the specification, an expression "on the plane" or "in a plan view" may indicate a case where a target is viewed from the top, and an expression "on the cross-section" in a cross-sectional view may indicate a case where a cross-section of a target taken along a vertical direction is viewed from its side.

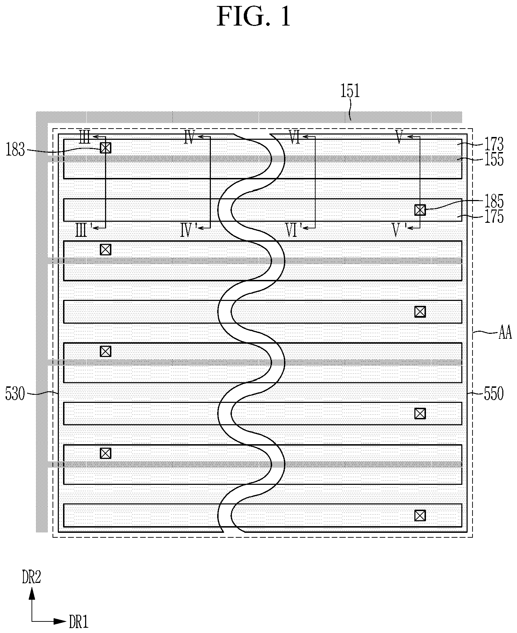

Hereinafter, the description describes a semiconductor device according to an embodiment with reference to FIGS. 1 to 6.

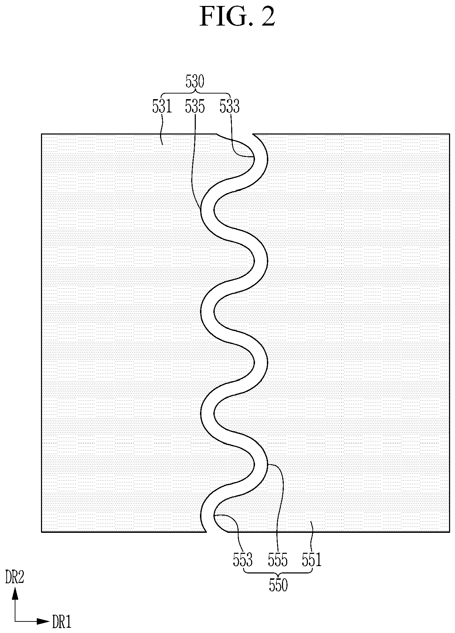

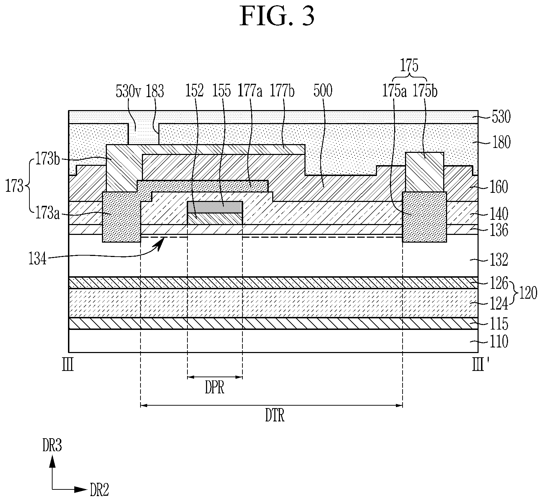

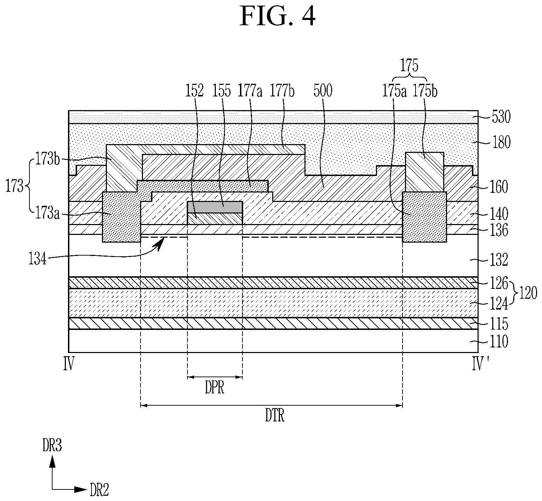

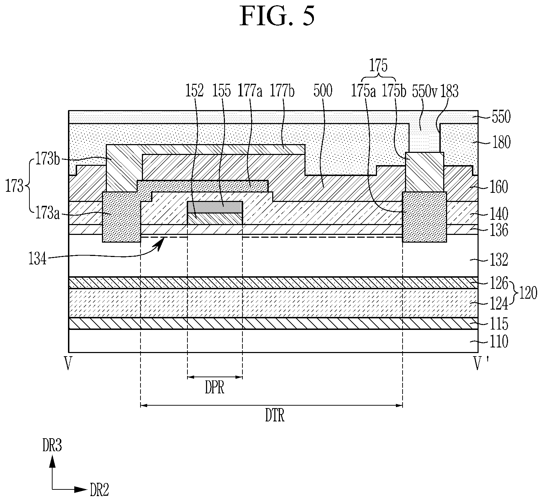

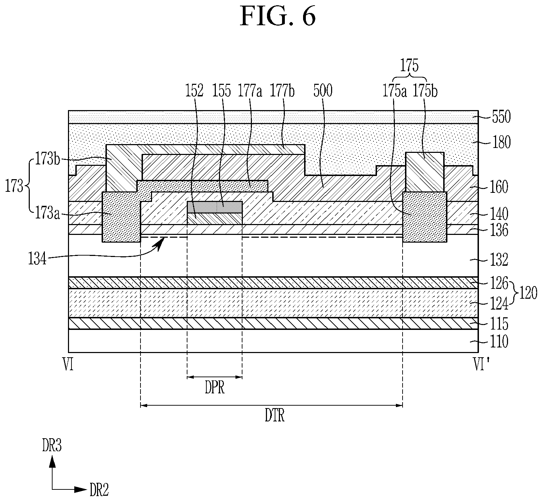

FIG. 1 is a plan view showing a semiconductor device according to an embodiment, and FIG. 2 is a plan view showing some layers of the semiconductor device according to an embodiment. FIG. 2 illustrates the source bus line and drain bus line of the semiconductor device according to an embodiment, and omits illustration of the other components. FIG. 3 is a cross-sectional view taken along line III-III' of FIG. 1, and FIG. 4 is a cross-sectional view taken along line IV-IV' of FIG. 1. FIG. 5 is a cross-sectional view taken along line V-V' of FIG. 1, and FIG. 6 is a cross-sectional view taken along line VI-VI' of FIG. 1.

As shown in FIGS. 1 to 6, the semiconductor device according to an embodiment may include a channel layer 132, a barrier layer 136 disposed on the channel layer 132, a gate electrode 155 disposed above the barrier layer 136, a gate semiconductor layer 152 disposed between the barrier layer 136 and the gate electrode 155, a source electrode 173 and a drain electrode 175, disposed on the channel layer 132 while being spaced apart from each other, a source bus line 530 connected to the source electrode 173, and a drain bus line 550 connected to the drain electrode 175.

The channel layer 132 may be a layer forming a channel between the source electrode 173 and the drain electrode 175, and a two-dimensional electron gas (2DEG) 134 may be disposed in the channel layer 132. The 2DEG 134 may be a charge transport model used in solid state physics, and indicates a group of electrons which may be freely moved in two dimensions (for example, an x-y plane direction), cannot be moved in another dimension (for example, a z direction), and are tightly bound within the two dimensions. That is, the 2DEG 134 may exist in a two-dimensional paper-like form within a three-dimensional space. The 2DEG 134 may mainly appear in a semiconductor heterojunction structure, and may occur at an interface between the channel layer 132 and the barrier layer 136 in the semiconductor device according to an embodiment. For example, the 2DEG 134 may occur in a portion closest to the barrier layer 136 within the channel layer 132. An active region AA may be defined in the semiconductor device according to an embodiment, and a plurality of channels may be formed in the active region AA. That is, the active region AA may include a plurality of regions where the 2DEG 134 occurs. The active region AA may have a quadrangular shape on a plane that includes two sides in a first direction DR1 and two sides in a second direction DR2 that intersects the first direction DR1. Here, the second direction DR2 may be orthogonal to the first direction DR1. The first direction DR1 and second direction DR2 may be orthogonal to a third direction DR3 (e.g. a height direction). The plurality of the gate electrodes 155, the plurality of the source electrodes 173, and the plurality of the drain electrodes 175 may be disposed in the active region AA.

The channel layer 132 may include Group III-V materials, for example, one or more materials selected from nitrides including at least one of aluminum (Al), gallium (Ga), indium (In), and Boron (B). The channel layer 132 may include a single layer or multiple layers. The channel layer 132 may be AlₓIn_{y}Ga_{1-x-y}N(0≤x≤1, 0≤y≤1, x+y≤1). For example, the channel layer 132 may include at least one of aluminum nitride (AIN), gallium nitride (GaN), indium nitride (InN), indium gallium nitride (InGaN), aluminum gallium nitride (AlGaN), aluminum indium nitride (AllnN), and aluminum-indium-gallium nitride (AllnGaN). The channel layer 132 may be a layer doped with an impurity or a layer undoped with an impurity. A thickness of the channel layer 132 may be about several hundred nm or less.

The channel layer 132 may be disposed above a substrate 110, and a seed layer 115, a buffer layer 120, or the like may be disposed between the substrate 110 and the channel layer 132. The substrate 110, the seed layer 115, and the buffer layer 120 may be layers used to form the channel layer 132, but may be omitted in some cases. For example, at least one of the substrate 110, the seed layer 115, and the buffer layer 120 may be omitted when the substrate including gallium nitride (GaN) is used as the channel layer 132. The channel layer 132 including GaN may be grown using the substrate 110 including silicon (Si) considering that the substrate including gallium nitride (GaN) is relatively expensive. Here, as a lattice structure of silicon (Si) and that of gallium nitride (GaN) are different from each other, it may not be easy to grow the channel layer 132 directly on the substrate 110. Accordingly, the seed layer 115 and the buffer layer 120 may be first grown on the substrate 110, and the channel layer 132 may then be grown on the buffer layer 120. In addition, at least one of the substrate 110, the seed layer 115, and the buffer layer 120 may be used in a manufacturing process and then removed from a final structure of the semiconductor device.

The substrate 110 may include a semiconductor material. For example, the substrate 110 may include sapphire, silicon (Si), SiC (silicon carbide), aluminum nitride (AIN), gallium nitride (GaN), or a combination thereof. The substrate 110 may be a silicon-on-insulator (SOI) substrate. However, the substrate 110 is not limited to such a material, and may use any commonly-used material of a substrate. In some cases, the substrate 110 may include an insulating material. For example, several layers including the channel layer 132 may be first formed on a semiconductor substrate, and then the semiconductor substrate may be removed and replaced with an insulating substrate.

The seed layer 115 may be disposed on the substrate 110. The seed layer 115 may be disposed directly on the substrate 110. However, the disclosure is not limited thereto, and another layer may be further disposed between the substrate 110 and the seed layer 115. The seed layer 115 may be a layer serving as a seed for growing the buffer layer 120, and may include a crystal lattice structure that becomes the seed of the buffer layer 120. For example, the seed layer 115 may include aluminum nitride (AIN), and is not limited thereto.

The buffer layer 120 may be disposed on the seed layer 115. The buffer layer 120 may be disposed directly on the seed layer 115. However, the disclosure is not limited thereto, and another layer may be further disposed between the seed layer 115 and the buffer layer 120. The buffer layer 120 may be disposed between the seed layer 115 and the channel layer 132. The buffer layer 120 may include the Group III-V materials, for example, one or more materials selected from nitrides including at least one of aluminum (Al), gallium (Ga), indium (In), and Boron (B). The buffer layer 120 may be AlₓIn_{y}Ga_{1-x-y}N(0≤x≤1, 0≤y≤1, x+y≤1). For example, the buffer layer 120 may include at least one of aluminum nitride (AIN), gallium nitride (GaN), indium nitride (InN), indium gallium nitride (InGaN), aluminum gallium nitride (AlGaN), aluminum indium nitride (AllnN), and aluminum-indium-gallium nitride (AllnGaN). The buffer layer 120 may include a single layer or multiple layers. The buffer layer 120 may include a superlattice layer 124 and a high-resistance layer 126 disposed on the superlattice layer 124. The high-resistance layer 126 may be disposed on the superlattice layer 124. The buffer layer 120 may omit at least one of the superlattice layer 124 and the high-resistance layer 126. In some cases, the buffer layer 120 may further include another layer in addition to the superlattice layer 124 and the high-resistance layer 126.

The superlattice layer 124 may be disposed on the seed layer 115. The superlattice layer 124 may be disposed directly on the seed layer 115. However, the disclosure is not limited thereto, and another layer may be further disposed between the seed layer 115 and the superlattice layer 124. The superlattice layer 124 may be disposed between the substrate 110 and the channel layer 132. The superlattice layer 124 may be a layer for alleviating a difference in the lattice constant and thermal expansion coefficient of the substrate 110 and those of the channel layer 132, thereby relieving a tensile stress and a compressive stress, occurring between the substrate 110 and the channel layer 132, and relieving a stress between all the layers formed by the growth in the final structure of the semiconductor device according to an embodiment. The superlattice layer 124 may include the Group III-V materials, for example, one or more materials selected from nitrides including at least one of aluminum (Al), gallium (Ga), indium (In), and Boron (B). Therefore, the superlattice layer 124 may be a nitride layer. The superlattice layer 124 may be AlₓIn_{y}Ga_{1-x-y}N(0≤x≤1, 0≤y≤1, x+y≤1). For example, the superlattice layer 124 may include at least one of aluminum nitride (AIN), gallium nitride (GaN), indium nitride (InN), indium gallium nitride (InGaN), aluminum gallium nitride (AlGaN), aluminum indium nitride (AllnN), and aluminum-indium-gallium nitride (AllnGaN). The superlattice layer 124 may include a single layer or multiple layers. For example, the superlattice layer 124 may have a layer including aluminum gallium nitride (AlGaN) and a layer including gallium nitride (GaN) which are repeatedly stacked. For example, AIGaN/GaN/AIGaN/GaN/AIGaN/GaN may be sequentially stacked on the seed layer 115 to form the superlattice layer 124. The number of AlGaN layers and GaN layers, which are included in the superlattice layer 124, may be changed in various ways, and a material included in the superlattice layer 124 may be changed in various ways.

The high-resistance layer 126 may be disposed on the superlattice layer 124. The high-resistance layer 126 may be disposed directly on the superlattice layer 124. However, the disclosure is not limited thereto, and another layer may be further disposed between the superlattice layer 124 and the high-resistance layer 126. The high-resistance layer 126 may be disposed between the superlattice layer 124 and the channel layer 132. The high-resistance layer 126 may be a layer for preventing the deterioration of the semiconductor device according to an embodiment by preventing a leakage current from flowing through the channel layer 132. The high-resistance layer 126 may include a low-conductivity material to electrically insulate between the substrate 110 and the channel layer 132. The high-resistance layer 126 may have a resistivity value of 1.0×10⁶ Ω·cm or more. For example, the resistivity value of the high-resistance layer 126 may be 1.0×10¹⁰ Ω·cm or more. For another example, the resistivity value of the high-resistance layer 126 may be 1.0×10¹² Ω·cm or more. The resistance value can be measured by forming a measuring electrode within the high-resistance layer 126 and causing a current to flow. The high-resistance layer 126 may include the Group III-V materials, for example, one or more materials selected from nitrides including at least one of aluminum (Al), gallium (Ga), indium (In), and Boron (B). Therefore, the high-resistance layer 126 may be a nitride layer. The high-resistance layer 126 may be AlₓIn_{y}Ga_{1-x-y}N(0≤x≤1, 0≤y≤1, x+y≤1). For example, the high-resistance layer 126 may include at least one of aluminum nitride (AIN), gallium nitride (GaN), indium nitride (InN), indium gallium nitride (InGaN), aluminum gallium nitride (AlGaN), aluminum indium nitride (AllnN), and aluminum-indium-gallium nitride (AllnGaN). The high-resistance layer 126 may include a single layer or multiple layers. The high-resistance layer 126 may be a layer undoped with an impurity. However, the disclosure is not limited thereto, and the high-resistance layer 126 may include an impurity. For example, the high-resistance layer 126 may be doped with an impurity including of carbon (C), magnesium (Mg), iron (Fe), or a combination thereof. An impurity doping concentration of the high-resistance layer 126 may be different from an impurity doping concentration of the channel layer 132.

The barrier layer 136 may be disposed on the channel layer 132. The barrier layer 136 may be disposed directly on the channel layer 132. However, the disclosure is not limited thereto, and another layer may be further disposed between the channel layer 132 and the barrier layer 136. A region of the channel layer 132 that overlaps the barrier layer 136 may be a drift region DTR. The drift region DTR may be disposed between the source electrode 173 and the drain electrode 175. When a potential difference occurs between the source electrode 173 and the drain electrode 175, a carrier may be moved in the drift region DTR. The semiconductor device according to an embodiment may be turned on/off based on whether a voltage is applied to the gate electrode 155 and a magnitude of the voltage applied to the gate electrode 155. A channel may be generated in a depletion region DPR when a voltage of a threshold voltage or more is applied to the gate electrode 155 and the semiconductor device is thus turned on. Accordingly, the carrier may be moved in the drift region DTR. A channel path may be blocked and the carrier may not be moved, in the depletion region DPR when a voltage less than the threshold voltage or no voltage is applied to the gate electrode 155.

The barrier layer 136 may include the Group III-V materials, for example, one or more materials selected from nitrides including at least one of aluminum (Al), gallium (Ga), indium (In), and Boron (B). The barrier layer 136 may therefore be a nitride layer. The barrier layer 136 may be AlₓIn_{y}Ga_{1-x-y}N(0≤x≤1, 0≤y≤1, x+y≤1). The barrier layer 136 may include at least one of gallium nitride (GaN), indium nitride (InN), aluminum gallium nitride (AlGaN), aluminum indium nitride (AllnN), indium gallium nitride (InGaN), aluminum nitride (AIN), and aluminum-indium-gallium nitride (AllnGaN). An energy band gap of the barrier layer 136 may be adjusted by a composition ratio of aluminum (Al) and/or indium (In). The barrier layer 136 may be doped with a predetermined impurity. Here, the impurity doped in the barrier layer 136 may be a p-type dopant that may provide a hole. For example, the impurity doped in the barrier layer 136 may be magnesium (Mg). The threshold voltage, on-resistance or the like of the semiconductor device according to an embodiment may be adjusted by increasing or lowering an impurity doping concentration of the barrier layer 136.

The barrier layer 136 may include a semiconductor material with a different feature from that of the channel layer 132. The barrier layer 136 may be different from the channel layer 132 in at least one of a polarization feature, the energy band gap, and the lattice constant. For example, the barrier layer 136 may include a material with the energy band gap different from that of the channel layer 132. Here, the barrier layer 136 may have a higher energy band gap than the channel layer 132, and may have a higher electrical polarization than the channel layer 132. The 2DEG 134 may be induced in the channel layer 132, which has relatively low electrical polarization, by the barrier layer 136. In this respect, the barrier layer 136 may also be referred to as a channel supply layer or a two-dimensional electron gas supply layer. The 2DEG 134 may be formed in a portion of the channel layer 132 that is disposed below the interface between the channel layer 132 and the barrier layer 136. The 2DEG 134 may have very high electron mobility.

The barrier layer 136 may include a single layer or multiple layers. When the barrier layer 136 includes the multiple layers, a material of each layer included in the multiple layers may have a different energy band gap. In this case, the multiple layers included in the barrier layer 136 may be arranged so that the closer the layer is to the channel layer 132, the larger the energy band gap is.

The gate electrode 155 may be disposed on the barrier layer 136. The gate electrode 155 may overlap some regions of the barrier layer 136. The gate electrode 155 may overlap some of the drift region DTR of the channel layer 132. The gate electrode 155 may be disposed between the source electrode 173 and the drain electrode 175. The gate electrode 155 may be spaced apart from the source electrode 173 and the drain electrode 175 (e.g. in the second direction DR2). The gate electrode 155 may extend lengthwise in the first direction DR1, as viewed from a plane view from the third direction DR3. For example, the gate electrode 155 may have a rod shape extending lengthwise in the first direction DR1. An item, layer, or portion of an item or layer described as extending "lengthwise" in a particular direction has a length in the particular direction and a width perpendicular to that direction, where the length is greater than the width. A semiconductor device according to an embodiment may include a plurality of the gate electrodes 155, and the plurality of the gate electrodes 155 may be arranged to be spaced apart from each other in the second direction DR2 which intersects the first direction DR1. The plurality of the gate electrodes 155 may be connected to a gate voltage supply line 151 to thus receive the same gate voltage. The gate voltage supply line 151 may be disposed outside the active region AA, and may surround at least a portion of the active region AA. For example, the gate voltage supply line 151 may extend in the first direction DR1 along an upper edge of the active region AA on the plane, may be bent along a corner of the active region AA, and extend in the second direction DR2 along a left edge of the active region AA. The plurality of the gate electrodes 155 may extend from and may be branched from a portion of the gate voltage supply line 151 that is disposed along the left edge of the active region AA. The gate voltage supply line 151 and the plurality of the gate electrodes 155 may be disposed at the same layer and at the same time (e.g., may form the same layer), and may be integrated with each other to form a single monolithic piece of material. However, the disclosure is not limited thereto, and the shapes of the gate electrode 155 and the gate voltage supply line 151 and their connection relationships may be changed in various ways. For example, the gate electrode 155 and the gate voltage supply line 151 may be disposed in different layers, and may be connected to each other through an insulating layer disposed therebetween.

The gate electrode 155 may include a conductive material. For example, the gate electrode 155 may include a metal, metal alloy, conductive metal nitride, metal silicide, doped semiconductor material, conductive metal oxide, conductive metal nitride, or the like. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), and titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel Platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), indium (Ir), osmium (Os), silver (Ag), gold (Au), zinc (Zn), vanadium (V), or a combination thereof, and is limited thereto. The gate electrode 155 may include a single layer or multiple layers.

The gate semiconductor layer 152 may be disposed between the barrier layer 136 and the gate electrode 155. For example, the gate semiconductor layer 152 may be disposed on the barrier layer 136, and the gate electrode 155 may be disposed on the gate semiconductor layer 152. The gate electrode 155 may be in Schottky contact with the gate semiconductor layer 152. However, the disclosure is not limited thereto, and in some cases, the gate electrode 155 may be in ohmic contact with the gate semiconductor layer 152. The gate semiconductor layer 152 may overlap the gate electrode 155. Here, the gate semiconductor layer 152 may completely overlap the gate electrode 155 in a third direction DR3. The third direction DR3 may be a direction perpendicular to the first direction DR1 and the second direction DR2, and may be perpendicular to an upper surface of the channel layer 132 or that of the barrier layer 136. An upper surface of the gate semiconductor layer 152 may be entirely covered by the gate electrode 155. For example, in some embodiments, the gate semiconductor layer 152 may have a plane shape substantially the same as the gate electrode 155 and may have a location and an orientation, from a plan view, substantially the same as the gate electrode 155, so that the gate semiconductor layer 152 and gate electrode mutually fully overlap each other in a plan view.

The gate semiconductor layer 152 may be disposed between the source electrode 173 and the drain electrode 175. The gate semiconductor layer 152 may be horizontally spaced apart from the source electrode 173 and the drain electrode 175. The gate semiconductor layer 152 may be disposed to be closer to the source electrode 173 than it is to the drain electrode 175. That is, a separation distance between the gate semiconductor layer 152 and the source electrode 173 may be smaller than a separation distance between the gate semiconductor layer 152 and the drain electrode 175.

The gate semiconductor layer 152 may include the Group III-V materials, for example, one or more materials selected from nitrides including at least one of aluminum (Al), gallium (Ga), indium (In), and Boron (B). The gate semiconductor layer 152 may be AlₓIn_{y}Ga_{1-x-y}N(0≤x≤1, 0≤y≤1, x+y≤1). For example, the gate semiconductor layer 152 may include at least one of aluminum nitride (AIN), gallium nitride (GaN), indium nitride (InN), indium gallium nitride (InGaN), aluminum gallium nitride (AlGaN), aluminum indium nitride (AllnN), and aluminum-indium-gallium nitride (AllnGaN). The gate semiconductor layer 152 may include a material with a different energy band gap from that of the barrier layer 136. For example, the gate semiconductor layer 152 may include gallium nitride (GaN), and the barrier layer 136 may include aluminum gallium nitride (AlGaN). The gate semiconductor layer 152 may be doped with a predetermined impurity. Here, the impurity doped in the gate semiconductor layer 152 may be the p-type dopant that may provide holes. For example, the gate semiconductor layer 152 may include gallium nitride (GaN) doped with the p-type impurity. Therefore, the gate semiconductor layer 152 may be a p-GaN layer. However, the disclosure is not limited thereto, and the gate semiconductor layer 152 may be a p-AlGaN layer. The impurity doped in the gate semiconductor layer 152 may be magnesium (Mg). The gate semiconductor layer 152 may include a single layer or multiple layers.

The depletion region DPR may be formed in the channel layer 132 by the gate semiconductor layer 152. The depletion region DPR may be disposed in the drift region DTR and may have a smaller width than the drift region DTR. The gate semiconductor layer 152 which has the energy band gap different from that of the barrier layer 136 may be disposed on the barrier layer 136. Therefore, an energy band of a portion of the barrier layer 136 that overlaps the gate semiconductor layer 152 may have an increased level. Accordingly, the depletion region DPR may be formed in a region of the channel layer 132 that overlaps the gate semiconductor layer 152. The depletion region DPR may be a region in the channel path of the channel layer 132, in which the 2DEG 134 is not formed or may have a lower electron concentration than the other regions. For example, the depletion region DPR may be a region in the drift region DTR, where a flow of the 2DEG 134 is interrupted. Because the depletion region DPR is formed, a current may not flow between the source electrode 173 and the drain electrode 175, and the channel path may be blocked. Accordingly, the semiconductor device according to an embodiment may have a normally off feature.

That is, the semiconductor device according to an embodiment may be a normally off high electron mobility transistor (HEMT). As shown in FIG. 1, in a normal state where the voltage is not applied to the gate electrode 155, the depletion region DPR may exist, and the semiconductor device according to an embodiment may be in an off state. Although not shown, when the voltage of the threshold voltage or more is applied to the gate electrode 155, the depletion region DPR may disappear, and the 2DEG 134 may not be interrupted and may be continued in the drift region DTR. Therefore, the 2DEG 134 may be entirely formed in the channel path between the source electrode 173 and the drain electrode 175, and the semiconductor device according to an embodiment may be in an on state. In summary, the semiconductor device according to an embodiment may include semiconductor layers with the different electrical polarization features, and a semiconductor layer with a relatively large polarization may cause the 2DEG 134 in another semiconductor layer heterogeneously junctioned with the corresponding semiconductor layer. The 2DEG 134 may be used as a channel between the source electrode 173 and the drain electrode 175, and the continuation or interruption of the flow of the 2DEG 134 may be controlled by a bias voltage applied to the gate electrode 155. The flow of the 2DEG 134 may be blocked in a gate-off state, and the current may not flow between the source electrode 173 and the drain electrode 175. The flow of the 2DEG 134 may be continued in a gate-on state, the current may thus flow between the source electrode 173 and the drain electrode 175.

The description describes above the case where the semiconductor device according to an embodiment is the normally off HEMT, and is not limited thereto. For example, the semiconductor device according to an embodiment may be a normally-on HEMT. The normally-on HEMT may omit the gate semiconductor layer 152, and the gate electrode 155 may thus be disposed directly on the barrier layer 136. That is, the gate electrode 155 may be in contact with the barrier layer 136. In this structure, the 2DEG 134 may be used as a channel in a state where the voltage is not applied to the gate electrode 155, and the current may flow between the source electrode 173 and the drain electrode 175. In addition, when a negative voltage is applied to the gate electrode 155, the depletion region DPR, where the flow of the 2DEG 134 is interrupted, may be formed below the gate electrode 155.

The buffer layer 120, the superlattice layer 124, the high-resistance layer 126, the channel layer 132, the barrier layer 136, and the gate semiconductor layer 152, described above, may be sequentially stacked on the substrate 110. The semiconductor device according to an embodiment may omit at least one of the buffer layer 120, the superlattice layer 124, the high-resistance layer 126, the channel layer 132, the barrier layer 136, and the gate semiconductor layer 152. The buffer layer 120, the superlattice layer 124, the high-resistance layer 126, the channel layer 132, the barrier layer 136, and the gate semiconductor layer 152 may include the same semiconductor material. Here, the composition ratio of each layer may be different in consideration of the function of each layer, its performance required for the semiconductor device, or the like.

The semiconductor device according to an embodiment may further include protective layers 140 and 160 disposed on the barrier layer 136 and the gate electrode 155. The protective layers 140 and 160 may include the first protective layer 140 and a second protective layer 160 disposed on the first protective layer 140. The first protective layer 140 and second protective layer 160 may cover the upper surfaces of the barrier layer 136 and the gate electrode 155, and may cover side surfaces of the gate electrode 155 and the gate semiconductor layer 152. The lower surface of the first protective layer 140 may be in contact with the barrier layer 136, the gate electrode 155, and the gate semiconductor layer 152. An upper surface of the first protective layer 140 may be in contact with the second protective layer 160. The second protective layer 160 may be spaced apart from the barrier layer 136, the gate electrode 155, and the gate semiconductor layer 152 by the first protective layer 140. Accordingly, in some embodiments, the second protective layer 160 does not contact any of the barrier layer 136, the gate electrode 155, and the gate semiconductor layer 152.

The barrier layer 136, the gate electrode 155 and the like may be protected by the protective layers 140 and 160 and may be separated from other components. The first protective layer 140 and the second protective layer 160 may each include an insulating material. For example, the first protective layer 140 and the second protective layer 160 may each include oxide such as silicon dioxide (SiO₂) or aluminum oxide (Al₂O₃). As another example, the first protective layer 140 and the second protective layer 160 may each include nitride such as silicon nitride (SiN) or oxynitride such as silicon nitride (SiON). The first protective layer 140 and the second protective layer 160 may include the same material or may include different materials. When the first protective layer 140 and the second protective layer 160 are formed of the same material, a boundary between the first protective layer 140 and the second protective layer 160 may not be visible. Each of the first protective layer 140 and the second protective layer 160 may include a single layer or multiple layers.

The source electrode 173 and the drain electrode 175 may be disposed on the channel layer 132. The source electrode 173 and the drain electrode 175 may be spaced apart from each other (e.g. in the second direction DR2), and the gate electrode 155 and the gate semiconductor layer 152 may be disposed between the source electrode 173 and the drain electrode 175. The gate electrode 155 and the gate semiconductor layer 152 may be spaced apart from the source electrode 173 and the drain electrode 175. The source electrode 173 may be disposed on one side of the gate electrode 155, and may be electrically connected to the channel layer 132. The drain electrode 175 may be disposed on the other side of the gate electrode 155, and may be electrically connected to the channel layer 132. The source electrode 173 and the drain electrode 175 may be disposed outside the drift region DTR of the channel layer 132. An interface between the source electrode 173 and the channel layer 132 may be one edge of the drift region DTR. Likewise, the interface between the drain electrode 175 and the channel layer 132 may be the other edge of the drift region DTR. However, the disclosure is not limited thereto, and in some embodiments, the source electrode 173 and the drain electrode 175 are not disposed outside the drift region DTR of the channel layer 132. For example, the channel layer 132 may not be recessed, and the source electrode 173 and the drain electrode 175 may be disposed on the upper surface of the channel layer 132. Bottom surfaces of the source electrode 173 and the drain electrode 175 may be in contact with the uppermost surface of the channel layer 132. Portions of the channel layer 132 that are in contact with the source electrode 173 and the drain electrode 175 may each be doped at a high concentration. Here, the carrier passing through the 2DEG 134 may pass through the highly-doped portion of the channel layer 132, for example, an upper portion of the 2DEG 134, and be delivered to the source electrode 173 or the drain electrode 175. Therefore, according to this example, one or both of the source electrode 173 and the drain electrode 175 are not in contact with the 2DEG 134 in a horizontal direction. The horizontal direction refers to a direction parallel to the upper surface of the substrate 110.

The source electrode 173 and the drain electrode 175 may extend in the first direction DR1. For example, the source electrode 173 and the drain electrode 175 may each have the rod shape extending lengthwise in the first direction DR1. The source electrode 173 and the drain electrode 175 may extend to be parallel to each other. The source electrode 173 and the drain electrode 175 may extend to be parallel to the gate electrode 155. The semiconductor device according to an embodiment may include a plurality of the source electrodes 173 and a plurality of the drain electrodes 175, and the source electrodes 173 and the drain electrodes 175 may be disposed alternately in the second direction DR2. For example, the source electrode 173, the drain electrode 175, the source electrode 173, and the drain electrode 175 may be sequentially arranged from the upper edge of the active region AA toward its lower edge. The edges of the plurality of the source electrodes 173 and the plurality of the drain electrodes 175 may be aligned with each other. Left edges of the plurality of the source electrodes 173 and left edges of the plurality of the drain electrodes 175 may be disposed on a first virtual line parallel to the second direction DR2. Right edges of the plurality of the source electrodes 173 and the right edges of the plurality of the drain electrodes 175 may be disposed on a second virtual line parallel to the second direction DR2.

The source electrode 173 and the drain electrode 175 may each include a conductive material. For example, the source electrode 173 and the drain electrode 175 may each include a metal, a metal alloy, conductive metal nitride, metal silicide, the doped semiconductor material, conductive metal oxide, conductive metal nitride, or the like. For example, the source electrode 173 and the drain electrode 175 may each include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum Nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel Platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), indium (Ir), osmium (Os), silver (Ag), gold (Au), zinc (Zn), vanadium (V), or a combination thereof, and is limited thereto. The source electrode 173 and the drain electrode 175 may each include a single layer or multiple layers. The source electrode 173 and the drain electrode 175 may be in ohmic contact with the channel layer 132. A region in the channel layer 132, which is in contact with the source electrode 173 and the drain electrode 175 may be doped at a relatively high concentration compared to other regions.

The source electrode 173 may include a first source electrode 173a and a second source electrode 173b. The second source electrode 173b may be disposed on the first source electrode 173a. The first source electrode 173a may contact the channel layer 132 and may be electrically connected to the channel layer 132. The second source electrode 173b may not contact the channel layer 132, and may be electrically connected to the channel layer 132 through the first source electrode 173a.

The drain electrode 175 may include a first drain electrode 175a and a second drain electrode 175b. The second drain electrode 175b may be disposed on the first drain electrode 175a. The first drain electrode 175a may contact the channel layer 132 and may be electrically connected to the channel layer 132. The second drain electrode 175b may not contact the channel layer 132, and may be electrically connected to the channel layer 132 through the first drain electrode 175a.

The first source electrode 173a and the first drain electrode 175a may be disposed on (e.g. in an opening or trench within) the first protective layer 140. The first source electrode 173a and the first drain electrode 175a may be disposed at least in part between the first protective layer 140 and the second protective layer 160. Trenches passing through the first protective layer 140 and the barrier layer 136 and recessing the upper surface of the channel layer 132 may be disposed on both sides of the gate electrode 155 to be spaced apart from each other. The first source electrode 173a and the first drain electrode 175a may respectively be disposed in the trenches disposed on both the sides of the gate electrode 155. The first source electrode 173a and the first drain electrode 175a may respectively be formed to fill the trenches. In the trenches, the first source electrode 173a and the first drain electrode 175a may be in contact with the channel layer 132 and the barrier layer 136. The channel layer 132 may form the bottom and side walls of the trench, and the barrier layer 136 may form the side walls of the trench. Accordingly, the first source electrode 173a and the first drain electrode 175a may be in contact with the upper surface and side surface of the channel layer 132. In addition, the first source electrode 173a and the first drain electrode 175a may be in contact with the side surfaces of the barrier layer 136. For example, the first source electrode 173a and the first drain electrode 175a may cover the side surfaces of the channel layer 132 and the barrier layer 136. The upper surfaces of the first source electrode 173a and the first drain electrode 175a may protrude more than the upper surface of the first protective layer 140. In addition, at least one of the first source electrode 173a and the first drain electrode 175a may cover at least a portion of the upper surface of the first protective layer 140. The second protective layer 160 may be disposed on the first source electrode 173a and the first drain electrode 175a. At least a portion of the first source electrode 173a and that of the first drain electrode 175a may be covered by the second protective layer 160.

The semiconductor device according to an embodiment may further include a first field distribution layer 177a disposed on the first protective layer 140. The first field distribution layer 177a may be disposed between the source electrode 173 and the drain electrode 175. The first field distribution layer 177a may overlap the gate electrode 155 in the third direction DR3. The gate electrode 155 may be covered by the first field distribution layer 177a. The first field distribution layer 177a may be electrically connected to the source electrode 173. For example, the first field distribution layer 177a may be connected to the first source electrode 173a. The first field distribution layer 177a may include the same material as the first source electrode 173a and may be disposed in the same layer as the first source electrode 173a. The first field distribution layer 177a may be formed simultaneously in the same process as the first source electrode 173a. A boundary between the first field distribution layer 177a and the first source electrode 173a may not be clear- for example, a grain boundary may not exist -, and the first field distribution layer 177a may be integrated with the first source electrode 173a to form a single continuous monolithic structure. However, the disclosure is not limited thereto, and the first field distribution layer 177a may be a separate component separated from the first source electrode 173a, for example, to have a gap, or a boundary therebetween. In addition, the first field distribution layer 177a may be disposed in a different layer from the first source electrode 173a, and may be formed in a different process. In some cases, the first field distribution layer 177a may be electrically connected to the gate electrode 155. For example, an opening overlapping the gate electrode 155 may be formed in the first protective layer 140, and the first field distribution layer 177a may be formed in the opening and electrically connected to the gate electrode 155 through the opening. Here, the first field distribution layer 177a may not be connected to the source electrode 173.

The first field distribution layer 177a may serve to disperse an electric field concentrated around the gate electrode 155. In the gate-off state, the 2DEG 134 with a very high concentration may be disposed in a portion of the channel layer 132 that is disposed between the gate electrode 155 and the source electrode 173 and a portion of the channel layer 132 that is disposed between the gate electrode 155 and the drain electrode 175. When the electric field is concentrated on the gate electrode 155 and the gate semiconductor layer 152, the leakage current may be increased and the breakdown voltage may be reduced. The semiconductor device according to an embodiment may include the first field distribution layer 177a to thus disperse the electric field concentrated around the gate electrode 155. Accordingly, the semiconductor device may reduce the leakage current and increase the breakdown voltage.

The second source electrode 173b and the second drain electrode 175b may be disposed on (e.g. in an opening or trench within) the second protective layer 160. The opening passing through the second protective layer 160 may be disposed to overlap the first source electrode 173a, and the second source electrode 173b may be disposed in the opening. The second source electrode 173b may fill the inside of the opening. In the opening, the second source electrode 173b may be in contact with the first source electrode 173a. The second source electrode 173b may be connected to the first source electrode 173a through the opening. The other opening passing through the second protective layer 160 may be disposed to overlap the first drain electrode 175a, and the second drain electrode 175b may be disposed in the opening. The second drain electrode 175b may fill the inside of the opening. In the opening, the second drain electrode 175b may be in contact with the first drain electrode 175a. The second drain electrode 175b may be connected to the first drain electrode 175a through the opening. The upper surfaces of the second source electrode 173b and the second drain electrode 175b may protrude beyond an upper surface of the second protective layer 160. In addition, at least one of the second source electrode 173b and the second drain electrode 175b may cover at least a portion of the upper surface (e.g., top surface) of the second protective layer 160.

The opening filled with the second source electrode 173b may overlap the trench filled with the first source electrode 173a. However, the disclosure is not limited thereto, and in some cases, the opening and the trench may not overlap each other. The opening filled with the second source electrode 173b may be completely overlapped by the first source electrode 173a. However, the disclosure is not limited thereto, and in some cases, at least a portion of the opening filled with the second source electrode 173b may not be overlapped by the first source electrode 173a. In one embodiment, the second source electrode 173b may cover a side surface of the first source electrode 173a, and may be in contact with the upper surface of the first protective layer 140. A width of the opening filled with the second source electrode 173b may be similar to a width of the trench filled with the first source electrode 173a. However, a relationship between the width of the opening and the width of the trench is not limited thereto, and may be changed in various ways.

The opening filled with the second drain electrode 175b may overlap the trench filled with the first drain electrode 175a. However, the disclosure is not limited thereto, and in some cases, the opening and the trench may not overlap each other. The opening filled with the second drain electrode 175b may be completely overlapped by the first drain electrode 175a. However, the disclosure is not limited thereto, and in some cases, at least a portion of the opening filled with the second drain electrode 175b may not be overlapped by the first drain electrode 175a. In one embodiment, the second drain electrode 175b may cover a side surface of the first drain electrode 175a, and may be in contact with the upper surface of the first protective layer 140. A width of the opening filled with the second drain electrode 175b may be similar to a width of the trench filled with the first drain electrode 175a. However, a relationship between the width of the opening and the width of the trench is not limited thereto, and may be changed in various ways.

The semiconductor device according to an embodiment may further include a second field distribution layer 177b disposed on the second protective layer 160. The second field distribution layer 177b may form a field distribution layer together with the first field distribution layer. FIG. 1, which is a plan view, does not separately show the field distribution layer, and a portion pointed to by the source electrode 173 may partially indicate the field distribution layer. The second field distribution layer 177b may be disposed horizontally between the source electrode 173 and the drain electrode 175 (e.g., as viewed from a plan view). The second field distribution layer 177b may overlap the gate electrode 155 in the third direction DR3. The second field distribution layer 177b may overlap the first field distribution layer 177a in the third direction DR3. The gate electrode 155 and the first field distribution layer 177a may be covered by the second field distribution layer 177b. A width of the second field distribution layer 177b (e.g., in the second direction DR2) may be greater than a width of the first field distribution layer 177a. The second field distribution layer 177b may entirely cover the first field distribution layer 177a. However, the disclosure is not limited thereto, and the width and positional relationship of the first field distribution layer 177a and the second field distribution layer 177b may be changed in various ways. The second field distribution layer 177b may be electrically connected to the source electrode 173. For example, the second field distribution layer 177b may be connected to the second source electrode 173b. The second field distribution layer 177b may include the same material as the second source electrode 173b and may be disposed in the same layer as the second source electrode 173b. As used in some contexts, a layer as described herein may refer to a section of material that is formed in a single process and that results in a material being formed continuously between a top-most portion of the layer and a bottom-most portion of the layer. The second field distribution layer 177b may be formed simultaneously in the same process as the second source electrode 173b. A boundary between the second field distribution layer 177b and the second source electrode 173b may not be clear (e.g., there may be no grain boundary therebetween), and the second field distribution layer 177b may be integrated with the second source electrode 173b. However, the disclosure is not limited thereto, and the second field distribution layer 177b may be a separate component separated from the second source electrode 173b. In addition, the second field distribution layer 177b may be disposed in a different layer from the second source electrode 173b, and may be formed in a different process. In some cases, the second field distribution layer 177b may be electrically connected to the gate electrode 155. For example, the first field distribution layer 177a may be connected to the gate electrode 155 through the opening formed in the first protective layer 140, and the second field distribution layer 177b may be connected to the first field distribution layer 177a through the opening formed in the second protective layer 160.

In some cases, the semiconductor device may omit at least one of the field distribution layers 177a and 177b. For example, the semiconductor device according to an embodiment may include the first field distribution layer 177a, and may not include the second field distribution layer 177b. Alternatively, the semiconductor device according to an embodiment may include the second field distribution layer 177b, and may not include the first field distribution layer 177a. Alternatively, the semiconductor device according to an embodiment may include none of the first field distribution layer 177a and the second field distribution layer 177b.

The description describes above the case where the source electrode 173 includes the first source electrode 173a and the second source electrode 173b, the drain electrode 175 includes the first drain electrode 175a and the second drain electrode 175b, and the field distribution layers 177a and 177b include the first field distribution layer 177a and the second field distribution layer 177b. Each of the source electrode 173, the drain electrode 175, and the field distribution layers 177a and 177b may have a metal layer disposed below the second protective layer 160 and a metal layer disposed above the second protective layer 160. However, the disclosure is not limited thereto, and the source electrode 173, the drain electrode 175, and the field distribution layers 177a and 177b may include more metal layers or fewer metal layers. For example, a third protective layer may be disposed on the second source electrode 173b, the second drain electrode 175b, and the second field distribution layer 177b, and a third source electrode, a third drain electrode, and a third field distribution layer may be disposed on the third protective layer. Here, the third source electrode and the third drain electrode may respectively be connected to the second source electrode and the second drain electrode through the third protective layer. As another example, the semiconductor device may omit the second protective layer 160, the second source electrode 173b, and the second drain electrode 175b. The metal layer disposed below the second protective layer 160, for example, the first source electrode 173a, the first drain electrode 175a, and the first field distribution layer 177a may each include a single layer or multiple layers. Likewise, the metal layer disposed above the second protective layer 160, for example, the second source electrode 173b, the second drain electrode 175b, and the second field distribution layer 177b may each include a single layer or multiple layers.

The semiconductor device according to an embodiment may further include an interlayer insulating layer 180 disposed on the source electrode 173 and the drain electrode 175. The interlayer insulating layer 180 may cover the second source electrode 173b, the second drain electrode 175b, and the second protective layer 160. At least a portion of the upper surface and side surface of the second source electrode 173b may be covered by the interlayer insulating layer 180. At least a portion of the upper surface and side surface of the second drain electrode 175b may be covered by the interlayer insulating layer 180. The upper surface of the second protective layer 160 may be covered by the interlayer insulating layer 180. The interlayer insulating layer 180 may be in contact with the second source electrode 173b, the second drain electrode 175b, and the second protective layer 160. However, the disclosure is not limited thereto, and another layer may be further disposed between the second source electrode 173b, the second drain electrode 175b, the second protective layer 160, and the interlayer insulating layer 180.

The interlayer insulating layer 180 may include an insulating material. For example, the interlayer insulating layer 180 may include the insulating material such as silicon dioxide (SiO₂), aluminum oxide (Al₂O₃), silicon nitride (SiN), or silicon oxynitride (SiON). The interlayer insulating layer 180 may include the same material as the protective layer 140 or 160, or may include a different material. When the interlayer insulating layer 180 includes the same material as the second protective layer 160, a boundary between the interlayer insulating layer 180 and the second protective layer 160 may not be visible. The interlayer insulating layer 180 may include a single layer or multiple layers.

The source bus line 530 and the drain bus line 550 may be disposed on the interlayer insulating layer 180. The source bus line 530 and the drain bus line 550 may be spaced apart from each other, and may have a gap therebetween. The source bus line 530 and the drain bus line 550 may be disposed in the active region AA. The source bus line 530 and the drain bus line 550 may overlap the plurality of the source electrodes 173 and the plurality of the drain electrodes 175 in the third direction DR3. The source bus line 530 and the drain bus line 550 may overlap the plurality of the gate electrodes 155 in the third direction DR3. The source bus line 530 and the drain bus line 550 may also overlap the region where the 2DEG 134 is formed between the source electrode 173 and the drain electrode 175 in the third direction DR3. The source bus line 530 and the drain bus line 550 may each serve as a pad for connection to an external wire so that a voltage may be supplied from the outside. The source bus line 530 and the drain bus line 550 may be disposed in the active region AA, thereby improving the integration of the semiconductor device according to an embodiment.

The source bus line 530 may be connected to the source electrode 173, as can be seen, for example in FIG. 3. The interlayer insulating layer 180 may be disposed between the source electrode 173 and the source bus line 530. The interlayer insulating layer 180 may include a first opening 183 overlapping the source electrode 173 and the source bus line 530. The source bus line 530 may be electrically connected to the source electrode 173 through the first opening 183 passing through the interlayer insulating layer 180. The first opening 183 may be filled by a source via 530v. That is, the source via 530v may be disposed in the first opening 183. The source via 530v may be integrated with the source bus line 530, for example, to be formed of a continuously formed monolithic piece of material. The source bus line 530 may be connected to the source electrode 173 by the source via 530v. Here, the source bus line 530 may be connected to the second source electrode 173b. The source bus line 530 may be connected to the plurality of the source electrodes 173. The source bus line 530 may extend to intersect the source electrode 173, and may overlap the plurality of the source electrodes 173 and the plurality of the drain electrodes 175. That is, the source bus line 530 may extend in the second direction DR2, and overlap the plurality of the source electrodes 173 and the plurality of the drain electrodes 175 arranged to be spaced apart from each other in the second direction DR2. The source bus line 530 may be connected to each of the plurality of the source electrodes 173 spaced apart from each other in the second direction DR2.

The source bus line 530 may include a main wire part 531 (also described as a body or body portion) and a protrusion part 533 (also described as a protrusion) protruding from the main wire 531. The main wire part 531 may extend in the second direction DR2. The protrusion part 533 may protrude from the main wire part 531 in the first direction DR1. Though only one protrusion part 533 is labeled and is discussed below, as can be seen in FIG. 2, a plurality of protrusion parts, or protrusions 533 may be included. Accordingly, a plurality of protrusions 533 may be located down the length of the source bus line 530. More generally, items described in the singular herein may be provided in plural, as can be seen, for example, in the drawings. Thus, the description of a single item that is provided in plural should be understood to be applicable to the remaining plurality of items unless context indicates otherwise. The protrusion part 533 may have a width reduced as the protrusion part 533 is further away from the main wire part 531. Here, the width of the protrusion part 533 may be its length in the second direction DR2. The source bus line 530 may include one main wire part 531 and the plurality of the protrusion parts 533 protruding therefrom. The plurality of the protrusion parts 533 may be connected to one main wire part 531. A concave part 535 may be disposed between the protrusion parts 533 adjacent to each other (e.g. between each adjacent pair of protrusion parts 533). The source bus line 530 may include the main wire part 531, the protrusion part(s) 533, and the concave part(s) 535. In a plan view, the plurality of the protrusion parts 533 may be arranged in a line in the second direction DR2, and the plurality of the concave parts 535 may be arranged in a line in the second direction DR2. Each of the protrusion parts 533 and the concave parts 535 may include a curved surface, or curved edge. Each of the protrusion parts 533 and the concave parts 535 may extend beyond an end of the main wire part 531 (e.g., body portion), with the protrusion parts 533 having a convex shape and forming a convex extended portion and the concave parts 535 having a concave shape and forming a concave extended portion. The convex extended portion may also be described as a protruding extension portion, and the concave extended portion may also be described as a recessed extension portion. The plurality of the protrusion parts 533 and the plurality of the concave parts 535 may be arranged alternately in a plan view to have a wave shape (e.g. a sinusoidal shape). The main wire part 531 may overlap the source electrode 173 and the drain electrode 175 in the third direction DR3. The protrusion part 533 may overlap the source electrode 173 in the third direction DR3, and the concave part 535 may overlap the drain electrode 175 in the third direction DR3. However, an overlap relationship between the source bus line 530, the source electrode 173, and the drain electrode 175 is not limited thereto, and may be changed in various ways.

The drain bus line 550 may be connected to the drain electrode 175 (see, e.g., FIG. 5). The interlayer insulating layer 180 may be disposed between the drain electrode 175 and the drain bus line 550. The interlayer insulating layer 180 may include a second opening 185 overlapping the drain electrode 175 and the drain bus line 550. The drain bus line 550 may be electrically connected to the drain electrode 175 through the second opening 185 passing through the interlayer insulating layer 180. The second opening 185 may be filled by a drain via 550v. That is, the drain via 550v may be disposed in the second opening 185. The drain via 550v may be integrated with the drain bus line 550. The drain bus line 550 may be connected to the drain electrode 175 by the drain via 550v. Here, the drain bus line 550 may be connected to the second drain electrode 175b. The drain bus line 550 may be connected to the plurality of the drain electrodes 175. The drain bus line 550 may extend to intersect the drain electrode 175 and may overlap the plurality of the source electrodes 173 and the plurality of the drain electrodes 175 in the third direction DR3. That is, the drain bus line 550 may extend in the second direction DR2, and overlap the plurality of the source electrodes 173 and the plurality of the drain electrodes 175, arranged to be spaced apart from each other in the second direction DR2, in the third direction DR3. The drain bus line 550 may be connected to the plurality of the drain electrodes 175 spaced apart from each other in the second direction DR2.

The drain bus line 550 may include a main wire part 551 and a protrusion part 553 (e.g., protrusion) protruding from the main wire part 551. The main wire part 551 may extend in the second direction DR2. The protrusion part 553 may protrude from the main wire part 551 in the first direction DR1. The protrusion part 553 may have a width reduced as the protrusion part 553 is further away from the main wire part 531. Here, the width of the protrusion part 553 may be its length in the second direction DR2. The drain bus line 550 may include one main wire part 551 and a plurality of the protrusion parts 553 protruding therefrom. The plurality of the protrusion parts 553 may be connected to one main wire part 551. A concave part 555 may be disposed between the protrusion parts 553 adjacent to each other (e.g. between each adjacent pair of protrusion parts 553). The drain bus line 550 may include the main wire part 551, the protrusion part(s) 553, and the concave part(s) 555. In a plan view, the plurality of the protrusion parts 553 may be arranged in a line in the second direction DR2, and the plurality of the concave parts 555 may be arranged in a line in the second direction DR2. Each of the protrusion parts 553 and the concave parts 555 may include a curved surface. The plurality of the protrusion parts 553 and the plurality of the concave parts 555 may be arranged alternately on the plane to have a wave shape (e.g. a sinusoidal shape). The main wire part 551 may overlap the source electrode 173 and the drain electrode 175 in the third direction DR3. The protrusion part 553 may overlap the drain electrode 175 in the third direction DR3, and the concave part 555 may overlap the source electrode 173 in the third direction DR3. However, an overlap relationship between the drain bus line 550, the source electrode 173, and the drain electrode 175 is not limited thereto, and may be changed in various ways.

The protrusion part(s) 533 of the source bus line 530 and the protrusion part(s) 553 of the drain bus line 550 may protrude in opposite directions. For example, the protrusion part 533 of the source bus line 530 may protrude in a right direction from a right edge of the main wire part 531 of the source bus line 530. The protrusion part 553 of the drain bus line 550 may protrude in a left direction from a left edge of the main wire part 551 of the drain bus line 550. The protrusion part(s) 530 of the source bus line 530 may protrude towards the drain bus line 550. The protrusion part(s) 550 of the drain bus line 550 may protrude towards the source bus line 530. The protrusion part 533 of the source bus line 530 and the concave part 555 of the drain bus line 550 may face each other. For example, the protrusion part 533 of the source bus line 530 and the concave part 555 of the drain bus line 550 may overlap each other in the first direction DR1. In addition, the concave part 535 of the source bus line 530 and the protrusion part 553 of the drain bus line 550 may face each other. For example, the concave part 535 of the source bus line 530 and the protrusion part 553 of the drain bus line 550 may overlap each other in the first direction DR1. The protrusion part 533 of the source bus line 530 and the protrusion part 553 of the drain bus line 550 may be arranged alternately in the second direction DR2. For example, in a plan view, a protrusion part 533 of the source bus line 530, a protrusion part 553 of the drain bus line 550, a protrusion part 533 of the source bus line 530, and a protrusion part 553 of the drain bus line 550, etc., may be sequentially arranged from the upper edge of the active region AA to its lower edge. The protrusions of the drain bus line 550 may be interleaved with the protrusions of the source bus line 530 to form structure of interleaved teeth, for example, so that all of the protrusions of both bus lines vertically overlap with an imaginary line extending in the second direction DR2.

A distance between the source bus line 530 and the drain bus line 550 (e.g., a length of a gap in the first direction DR1 between the source bus line 530 and the drain bus line 550) may be predetermined. A distance between the protrusion part 533 of the source bus line 530 and the concave part 555 of the drain bus line 550 may be substantially the same as a distance between the concave part 535 of the source bus line 530 and the protrusion part 553 of the drain bus line 550. A space between the source bus line 530 and the drain bus line 550 may have a wave shape (e.g. a sinusoidal shape) with a constant width. Here, the width may be the shortest distance from any point of the source bus line 530 to the drain bus line 550. For example, the shortest distance in the first direction DR1 between an inflection point of the concave part 535 of the source bus line 530 and an inflection point of the protrusion part 553 of the drain bus line 550 may be a distance between the source bus line 530 and the drain bus line 550. As another example, the shortest distance in a direction oblique to the first direction DR1 between a midpoint between the concave part 535 and protrusion part 533 of the source bus line 530 and a midpoint between the concave part 555 and protrusion part 553 of the drain bus line 550 may be the distance between the source bus line 530 and the drain bus line 550. That is, a channel of a constant width is formed between the source bus line 530 and the drain bus line 550 that follows a sinusoidal (or wave-like) path (e.g. as it extends along the second direction DR2).

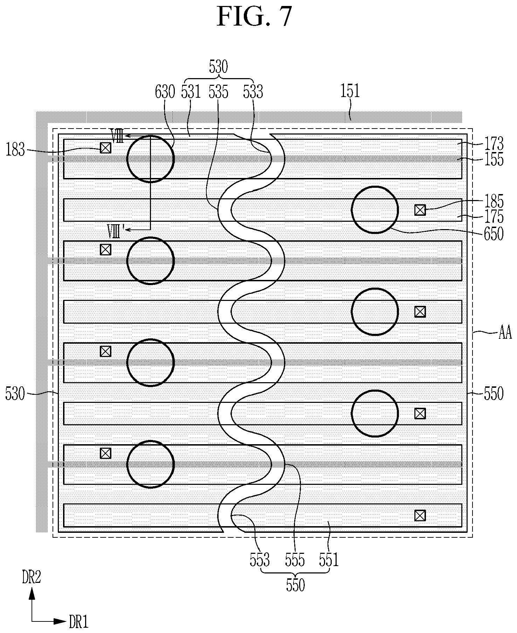

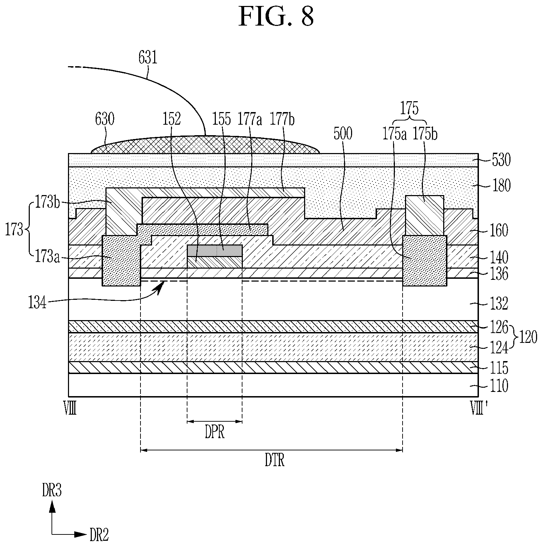

The semiconductor device according to an embodiment may be connected to the external wire to receive a predetermined voltage from the outside. For example, in the semiconductor device according to an embodiment, the source bus line 530 and the drain bus line 550 may each be connected to the external wire through wire bonding, a soldering process, or the like. Hereinafter, the description describes a case where a semiconductor device according to an embodiment is connected to the external wire through wire bonding with reference to FIGS. 7 and 8.

FIG. 7 is a plan view showing the semiconductor device according to an embodiment, and FIG. 8 is a cross-sectional view taken along line VIII-VIII' of FIG. 7.

As shown in FIGS. 7 and 8, the semiconductor device according to an embodiment may further include a source bonding part 630 connected to the source bus line 530, and a drain bonding part 650 connected to the drain bus line 550.

The source bonding part 630 may be disposed on the source bus line 530. The source bonding part 630 may be in contact with an upper surface of the source bus line 530. The source bonding part 630 may have a shape of a water droplet (e.g. a dome shape) on the upper surface of the source bus line 530. The source bonding part 630 may be described as a source bonding connector. The semiconductor device according to an embodiment may further include a source wire part 631 extending long like a thread from the source bonding part 630. The source wire part 631 may also be described as a source wire. Although not shown, the source bonding part 630 may be connected to an external wire through the source wire part 631. Therefore, the source bus line 530 may receive the predetermined voltage from the outside through the source bonding part 630 and transmit the same to the source electrode 173. For example, the source bus line 530 may be connected to an external circuit by a wire bonding method, including a bonding wire and a solder, for example. One source bus line 530 may be connected to the plurality of source bonding parts 630. The plurality of source bonding parts 630 may be disposed to be spaced apart from each other by a predetermined distance in the second direction DR2. The plurality of source bonding parts 630 are shown to be disposed in a line in the second direction DR2, and are not limited thereto. In some cases, the plurality of source bonding parts 630 may be disposed in a zigzag shape or the like.

The source bonding part 630 may overlap the protrusion part 533 of the source bus line 530 in the first direction DR1, as viewed from a plan view. For example, the source bonding part 630 and the protrusion part 533 of the source bus line 530 may be aligned in the first direction DR1. For example, a center point of the source bonding part 630 and the outermost point of the protrusion part 533 of the source bus line 530 may be disposed on one virtual line parallel to the first direction DR1. The source bonding part 630 may not overlap the concave part 535 of the source bus line 530 in the first direction DR1. The source bonding part 630 may overlap the concave part 555 of the drain bus line 550 in the first direction DR1. The number of source bonding parts 630 may correspond to the number of the protrusion parts 533 of the source bus line 530. For example, the number of source bonding parts 630 may be substantially the same as the number of protrusion parts 533 of the source bus line 530. Alternatively, the number of source bonding parts 630 may be half or twice the number of the protrusion parts 533 of the source bus line 530. In some cases, the source bonding part 630 may be disposed to overlap only some protrusion parts 533 of the source bus line 530 in the first direction DR1, or two or more source bonding parts 630 may be disposed to overlap each of the protrusion parts 533 of the source bus line 530 in the first direction DR1.

The source bonding part 630 may overlap the main wire part 531 of the source bus line 530 in the third direction DR3. The source bonding part 630 may not overlap the protrusion part 533 of the source bus line 530 in the third direction DR3. The source bonding part 630 may be disposed approximately in the center between a left edge of the source bus line 530 and the protrusion part 533. The source bonding part 630 may overlap the source electrode 173 in the third direction DR3. The source bonding part 630 may not overlap the first opening 183 in the third direction DR3. The source bonding part 630 may overlap the gate electrode 155 in the third direction DR3. However, a position of the source bonding part 630 is not limited thereto, and may be changed in various ways.

The drain bonding part 650 may be disposed on the drain bus line 550. The drain bonding part 650 may be in contact with an upper surface of the drain bus line 550. The drain bonding part 650 may have a shape of a water droplet (e.g. a dome shape) on the upper surface of the drain bus line 550. The drain bonding part 650 may be described as a drain bonding connector. Although not shown, the semiconductor device according to an embodiment may further include a drain wire part extending long like a thread from the drain bonding part 650. The drain wire part may be connected to the external wire. The drain wire part may also be described as a drain wire. Therefore, the drain bus line 550 may receive the predetermined voltage from the outside through the drain bonding part 650 and transmit the same to the drain electrode 175. For example, the drain bus line 550 may be connected to the external circuit by a wire bonding method, including a bonding wire and a solder, for example. One drain bus line 550 may be connected to the plurality of drain bonding parts 650. The plurality of drain bonding parts 650 may be disposed to be spaced apart from each other by a predetermined distance in the second direction DR2. The plurality of drain bonding parts 650 are shown to be disposed in a line in the second direction DR2, and are not limited thereto. In some cases, the plurality of drain bonding parts 650 may be disposed in the zigzag shape or the like.

The drain bonding part 650 may overlap the protrusion part 553 of the drain bus line 550 in the first direction DR1. For example, the drain bonding part 650 and the protrusion part 553 of the drain bus line 550 may be aligned in the first direction DR1. For example, a center point of the drain bonding part 650 and the outermost point of the protrusion part 553 of the drain bus line 550 may be disposed on one virtual line parallel to the first direction DR1. The drain bonding part 650 may not overlap the concave part 555 of the drain bus line 550 in the first direction DR1. The drain bonding part 650 may overlap the concave part 535 of the source bus line 530 in the first direction DR1. The number of drain bonding parts 650 may correspond to the number of the protrusion parts 553 of the drain bus line 550. For example, the number of drain bonding parts 650 may be substantially the same as the number of protrusion parts 553 of the drain bus line 550. Alternatively, the number of drain bonding parts 650 may be half or twice the number of the protrusion parts 553 of the drain bus line 550. In some cases, the drain bonding part 650 may be disposed to overlap only some protrusion parts 553 of the drain bus line 550 in the first direction DR1, or two or more drain bonding parts 650 may be disposed to overlap each protrusion parts 553 of the drain bus line 550 in the first direction DR1.

The drain bonding part 650 may overlap the main wire part 551 of the drain bus line 550 in the third direction DR3. The drain bonding part 650 may not overlap the protrusion part 553 of the drain bus line 530 in the third direction DR3. The drain bonding part 650 may be disposed approximately in the center between a left edge of the drain bus line 550 and the protrusion part 553. The drain bonding part 650 may overlap the drain electrode 175 in the third direction DR3. The drain bonding part 650 may not overlap the second opening 185 in the third direction DR3. The drain bonding part 650 may not overlap the gate electrode 155 in the third direction DR3. However, a position of the drain bonding part 650 is not limited thereto, and may be changed in various ways.

In the semiconductor device according to an embodiment, the source bus line 530 and the drain bus line 550, which serve as pads bonded to the source bonding part 630 and the drain bonding part 650 may respectively include the protrusion parts 533 and 553, and the protrusion part 533 of the source bus line 530 and the protrusion part 553 of the drain bus line 550 may be disposed alternately in an interleaved manner. A contact area between the pads of the source bonding part 630 and the drain bonding part 650 may be sufficiently secured by the protrusion part 533 of the source bus line 530 and the protrusion part 553 of the drain bus line 550. It is also possible to increase a degree of freedom in a formation position of the source bonding part 630 and that of the drain bonding part 650.

In a process of crimping the wires to form the source bonding part 630 and the drain bonding part 650, impact and damage may occur to the source bus line 530 or the drain bus line 550. In the semiconductor device according to an embodiment, the protrusion parts 533 and 553 of the source bus line 530 and the drain bus line 550 may have widths each gradually reduced as the protrusion parts are further away from the main wire parts 531 and 551. Accordingly, the impact applied to the source bus line 530 and the drain bus line 550 may be distributed in various directions, and the damage to the source bus line 530 and the drain bus line 550 may be prevented.

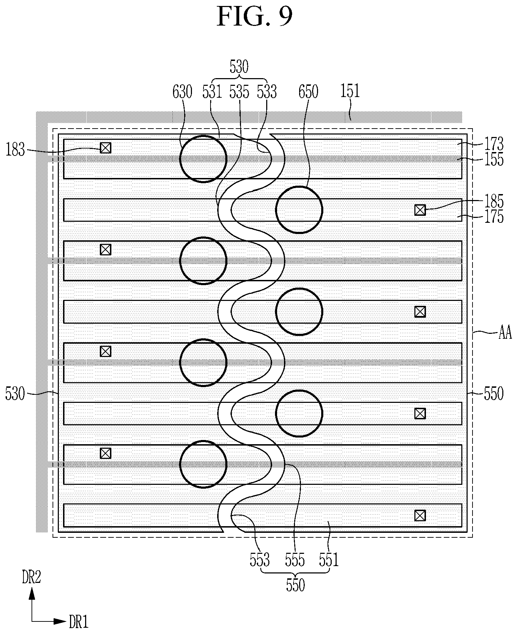

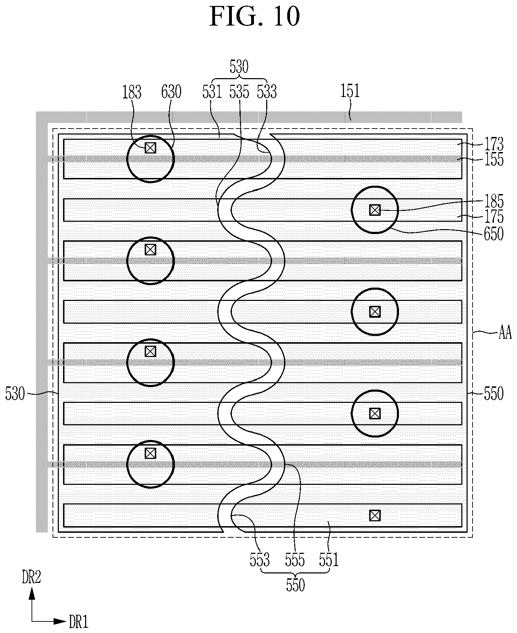

In the semiconductor device according to an embodiment, the positions of the source bonding part 630 and the drain bonding part 650 and their positional relationships with other components may be changed in various ways, and the description describes some modifications below with reference to FIGS. 9 and 10.

FIGS. 9 and 10 are plan views each showing a semiconductor device according to an embodiment.

As shown in FIG. 9, the source bonding part 630 may have at least a portion overlapping the main wire part 531 of the source bus line 530 in the third direction DR3, and another portion overlapping the protrusion part 533 of the source bus line 530 in the third direction DR3. For example, the source bonding part 630 may overlap the concave part 535 of the source bus line 530 in the second direction DR2. The drain bonding part 650 may have at least a portion overlapping the main wire part 551 of the drain bus line 550 in the third direction DR3, and another portion overlapping the protrusion part 553 of the drain bus line 550 in the third direction DR3. For example, the drain bonding part 650 may overlap the concave part 555 of the drain bus line 550 in the second direction DR2. Compared to the embodiment shown in FIG. 7, the source bonding part 630 may be shifted to the right, and the drain bonding part 650 may be shifted to the left.

As another example, the source bonding part 630 may be shifted to the left, and the drain bonding part 650 may be shifted to the right. As still another example, the source bonding part 630 and the drain bonding part 650 may all be shifted to the left or may all be shifted to the right.

As shown in FIG. 10, the source bonding part 630 may overlap the source electrode 173 and the first opening 183 in the third direction DR3. The source bonding part 630 may not overlap the drain electrode 175 in the third direction DR3. The drain bonding part 650 may overlap the drain electrode 175 and second opening 185 in the third direction DR3. The drain bonding part 650 may not overlap the source electrode 173 in the third direction DR3.

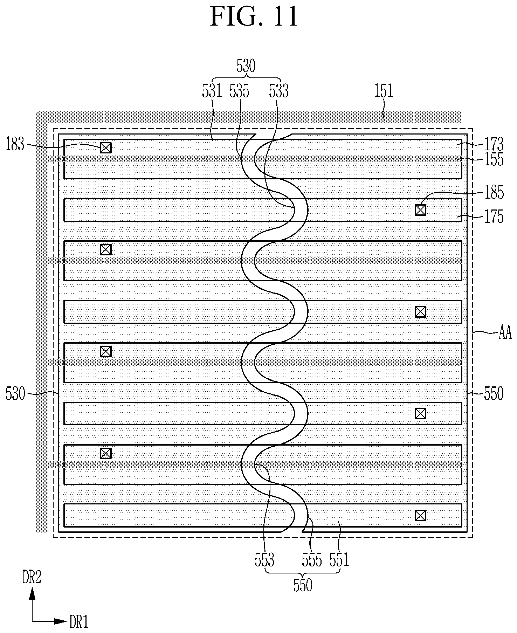

In the semiconductor device according to an embodiment, the shapes of the source bus line 530 and the drain bus line 550 may be changed in various ways, and the description describes some modifications below with reference to FIGS. 11 to 15.

FIGS. 11 to 15 are plan views showing a semiconductor device according to an embodiment.

As shown in FIG. 11, the protrusion part 533 of the source bus line 530 may overlap the drain electrode 175 in the third direction DR3, and may not overlap the source electrode 173 in the third direction DR3. The concave part 535 of the source bus line 530 may overlap the source electrode 173 in the third direction DR3, and may not overlap the drain electrode 175 in the third direction DR3. In this case, the source bonding part may overlap the drain electrode 175 in the third direction DR3, and may not overlap the source electrode 173 in the third direction DR3.

The protrusion part 553 of the drain bus line 550 may overlap the source electrode 173 in the third direction DR3, and may not overlap the drain electrode 175 in the third direction DR3. The concave part 555 of the drain bus line 550 may overlap the drain electrode 175 in the third direction DR3, and may not overlap the source electrode 173 in the third direction DR3. In this case, the drain bonding part may overlap the source electrode 173 in the third direction DR3, and may not overlap the drain electrode 175 in the third direction DR3.

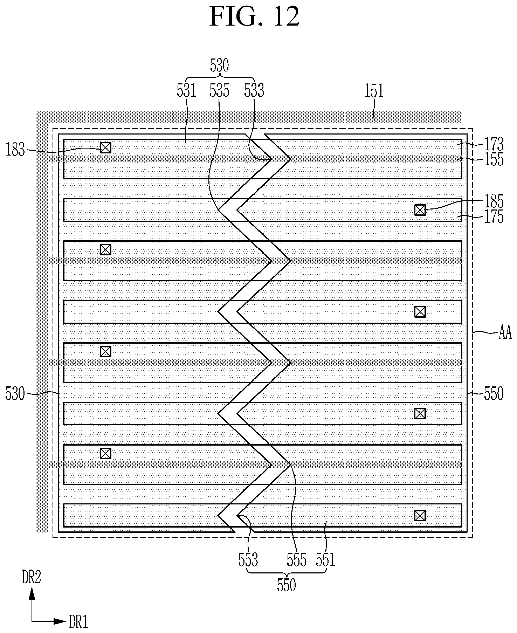

As shown in FIG. 12, the shapes of the protrusion part 533 and concave part 535 of the source bus line 530 and the protrusion part 553 and concave part 555 of the drain bus line 550 may be different from those in the embodiments described above. In the embodiments described above, each of the protrusion part 533 and concave part 535 of the source bus line 530 and the protrusion part 553 and concave part 555 of the drain bus line 550 may include the curved surface, and in this embodiment, each of the protrusion part 533 and concave part 535 of the source bus line 530 and the protrusion part 553 and concave part 555 of the drain bus line 550 may have an angular shape.

Each of the protrusion part 533 of the source bus line 530 and the protrusion part 553 of the drain bus line 550 may have an approximately triangular shape as viewed from a plan view. Each end of the protrusion part 533 of the source bus line 530 and the protrusion part 553 of the drain bus line 550 may have a pointed shape. Likewise, each end of the concave part 535 of the source bus line 530 and the concave part 555 of the drain bus line 550 may have the pointed shape. The space between the source bus line 530 and the drain bus line 550 may have the zigzag shape from a plan view.

In some cases, each of the protrusion part 533 of the source bus line 530 and the protrusion part 553 of the drain bus line 550 may have an approximately triangular shape in a plan view. However, each end of the protrusion part 533 of the source bus line 530 and the protrusion part 553 of the drain bus line 550 may have a rounded shape. Here, each end of the concave part 535 of the source bus line 530 and the concave part 555 of the drain bus line 550 may have the round shape. In this case, the remainder of the end edge of the source bus line 530 and drain bus line 550 other than the ends of the concave parts 535 and ends of the protrusion parts 533 may have a straight line shape.

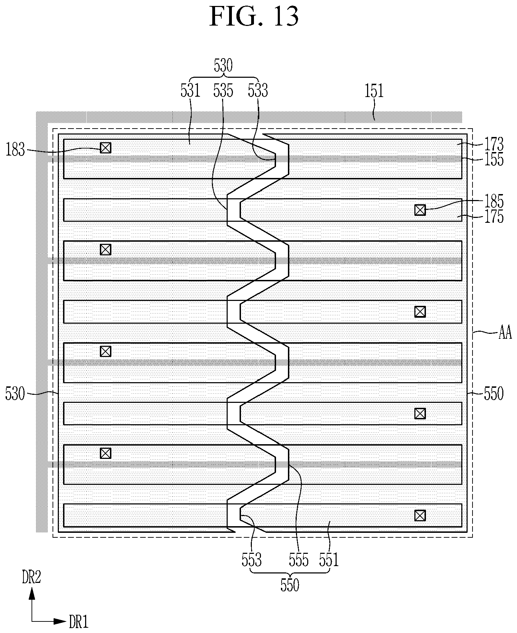

As shown in FIG. 13, each of the protrusion part 533 of the source bus line 530 and the protrusion part 553 of the drain bus line 550 may have an approximately trapezoidal shape on the plane. Each end of the protrusion part 533 of the source bus line 530 and the protrusion part 553 of the drain bus line 550 may include a side parallel to the second direction DR2. Likewise, each end of the concave part 535 of the source bus line 530 and the concave part 555 of the drain bus line 550 may include a side parallel to the second direction DR2.

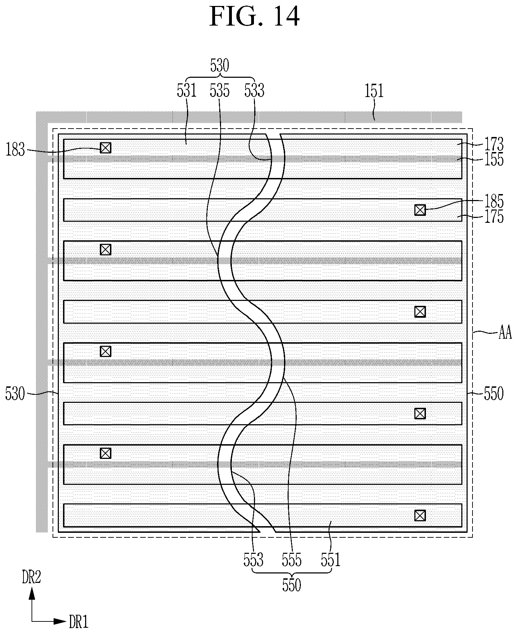

As shown in FIG. 14, the space between the source bus line 530 and the drain bus line 550 may have a wave shape (e.g. a sinusoidal shape) with a constant width like an embodiment described above. The space between the source bus line 530 and the drain bus line 550 may have the wave shape with a larger period compared to an embodiment described above. Here, the number of the protrusion parts 533 of the source bus line 530 and the number of the protrusion parts 553 of the drain bus line 550 may be less than in an embodiment described above.

The protrusion parts 533 of the source bus line 530 may overlap some source electrodes 173 among the plurality of the source electrodes 173 in the third direction DR3, and the concave parts 535 may overlap the other source electrodes 173 in the third direction DR3. For example, the protrusion part 533 of the source bus line 530 may overlap an odd numbered source electrode 173 in the third direction DR3. Here, the concave part 535 of the source bus line 530 may overlap an even numbered source electrode 173 in the third direction DR3. The number of the protrusion parts 533 of the source bus line 530 may be less than the number of the source electrodes 173. Although not shown, the source bonding part may be disposed to overlap the protrusion part 533 of the source bus line 530 in the first direction DR1. The number of source bonding parts may be substantially the same as the number of the protrusion parts 533 of the source bus line 530. The number of source bonding parts may be less than the number of the source electrodes 173.

The protrusion part 553 of the drain bus line 550 may overlap some source electrodes 173 among the plurality of the source electrodes 173 in the third direction DR3, and the concave parts 555 may overlap the other source electrodes 173 in the third direction DR3. For example, the protrusion part 553 of the drain bus line 550 may overlap the even numbered source electrode 173 in the third direction DR3. Here, the concave part 555 of the drain bus line 550 may overlap the odd numbered source electrode 173 in the third direction DR3. The number of the protrusion parts 553 of the drain bus line 550 may be less than the number of the drain electrodes 175. Although not shown, the drain bonding part may be disposed to overlap the protrusion part 553 of the drain bus line 550 in the first direction DR1. The number of drain bonding parts may be substantially the same as the number of the protrusion parts 553 of the drain bus line 550. The number of drain bonding parts may be less than the number of the drain electrodes 175.

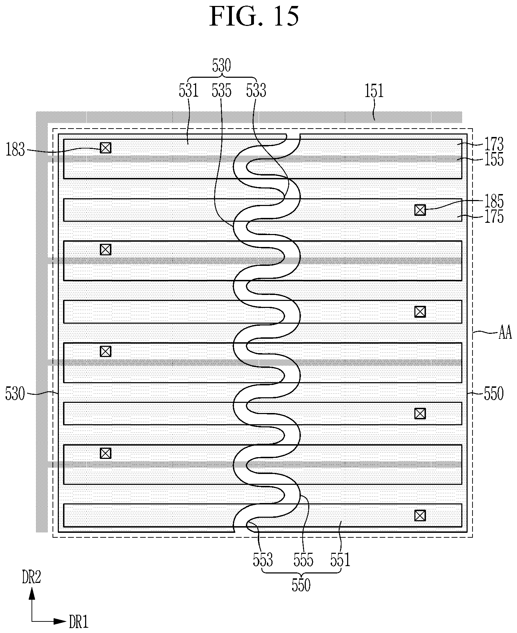

As shown in FIG. 15, the space between the source bus line 530 and the drain bus line 550 may have a wave shape (e.g. a sinusoidal shape) with a smaller period compared to an embodiment described above. Here, the number of the protrusion parts 533 of the source bus line 530 and the number of the protrusion parts 553 of the drain bus line 550 may be more than in an embodiment described above.

The number of the protrusion parts 533 of the source bus line 530 may be more than the number of the source electrodes 173. Here, one source electrode 173 may overlap both the protrusion part 533 and concave part 535 of the source bus line 530 in the third direction DR3. Although not shown, the source bonding part may be disposed to overlap the protrusion part 533 of the source bus line 530 in the first direction DR1. The number of source bonding parts may be substantially the same as the number of the protrusion parts 533 of the source bus line 530. The number of source bonding parts may be more than the number of the source electrodes 173.

The number of the protrusion parts 553 of the drain bus line 550 may be more than the number of the drain electrodes 175. Here, one drain electrode 175 may overlap both the protrusion part 553 and concave part 555 of the drain bus line 550 in the third direction DR3. Although not shown, the drain bonding part may be disposed to overlap the protrusion part 553 of the drain bus line 550 in the first direction DR1. The number of drain bonding parts may be substantially the same as the number of the protrusion parts 553 of the drain bus line 550. The number of drain bonding parts may be more than the number of the drain electrodes 175.

In addition, the shapes of the protrusion part 533 of the source bus line 530 and the protrusion part 553 of the drain bus line 550 may be changed in various ways. Accordingly, it is possible to increase a degree of freedom in a formation position of the wire bonding and prevent damage to the semiconductor device, by the protrusion parts 533 and 553.

Although the embodiments of the disclosure have been described in detail hereinabove, the scope of the disclosure is not limited thereto. That is, various modifications and alterations made by those skilled in the art by using a basic concept of the disclosure as defined in the following claims fall within the scope of the disclosure.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

The components that are described as "overlapping" in a particular direction may be at least partially obstructed by one another when viewed along a line extending in the particular direction. That is, the components may be positioned such that a line may be positioned that is parallel to that particular direction and that passes through at least a portion of both components.

Embodiments are set out in the following clauses:
Clause 1. A semiconductor device comprising:
   a channel layer;
   a barrier layer disposed on the channel layer, and including a material with an energy band gap different from that of the channel layer;
   a gate electrode disposed above the barrier layer, and extending in a first direction;
   a gate semiconductor layer disposed between the barrier layer and the gate electrode;
   a source electrode and a drain electrode, disposed on opposite sides of the gate electrode in a second direction intersecting the first direction, each extending in the first direction and connected to the channel layer;
   a source bus line disposed on the source electrode and the drain electrode, and connected to the source electrode; and
   a drain bus line spaced apart from the source bus line,
   wherein each of the source bus line and the drain bus line includes:
      a body portion extending in the second direction, and
      a plurality of protruding extension portions protruding from the body portion in the first direction,
      wherein each protruding extension portion of the plurality of protruding extension portions of the source bus line has a convex edge, and each protruding extension portion of the plurality of protruding extension portions of the drain bus line has a convex edge .
Clause 2. The semiconductor device of clause 1, wherein:
   each convex edge is a curved edge, and
   a space between the source bus line and the drain bus line has a wave shape with a constant width.
Clause 3. The semiconductor device of clause 1 or clause 2, wherein:
   each protruding extension portion of the source bus line has a width reduced as the protruding extension portion is further away from the body portion of the source bus line, and
   each protruding extension portion of the drain bus line has a width reduced as the protruding extension portion is further away from the body portion of the drain bus line.
Clause 4. The semiconductor device of any preceding clause, wherein:
   the protruding extension portions of the source bus line are alternatingly interleaved with the protruding extension portions of the drain bus line in the second direction.
Clause 5. A semiconductor device comprising:
   a channel layer;
   a barrier layer disposed on the channel layer, and including a material with an energy band gap different from that of the channel layer;
   a gate electrode disposed above the barrier layer, and extending in a first direction;
   a gate semiconductor layer disposed between the barrier layer and the gate electrode;
   a source electrode and a drain electrode, disposed on opposite sides of the gate electrode, extending in the first direction, and connected to the channel layer;
   a source bus line disposed on the source electrode and the drain electrode, and connected to the source electrode;
   a drain bus line spaced apart from the source bus line; and
   a source bonding connector in contact with an upper surface of the source bus line,
   wherein each of the source bus line and the drain bus line includes:
      a main wire part extending in a second direction intersecting the first direction, and
      a protrusion part protruding from the main wire part in the first direction, and
      wherein the source bonding connector overlaps the protrusion part of the source bus line in the first direction.
Clause 6. The semiconductor device of clause 5, further comprising:
   a drain bonding part in contact with an upper surface of the drain bus line,
   wherein the drain bonding part overlaps the protrusion part of the drain bus line in the first direction.

### <Description of symbols and example terms>

110: substrate
132: channel layer
136: barrier layer
155: gate electrode
173: source electrode
175: drain electrode
180: interlayer insulating layer
530: source bus line
531: main wiring part/body/body portion of source bus line
533: protrusion part/convex extended portion/protruding extension portion of source bus line
535: concave part/concave extended portion/recessed extension portion of source bus line
550: drain bus line
551: main wiring part/body/body portion of drain bus line
553: protrusion part/convex extended portion/protruding extension portion of drain bus line
555: concave part/concave extended portion/recessed extension portion of drain bus line
630: source bonding part/source bonding connector
650: drain bonding part/drain bonding connector

## Claims

1. A semiconductor device comprising:
a channel layer;
a barrier layer disposed on the channel layer, and including a material with an energy band gap different from that of the channel layer;
a gate electrode disposed above the barrier layer, and extending in a first direction;
a gate semiconductor layer disposed between the barrier layer and the gate electrode;
a source electrode and a drain electrode, respectively disposed on opposite sides of the gate electrode in a second direction intersecting the first direction, each extending in the first direction and connected to the channel layer;
a source bus line disposed on the source electrode and the drain electrode, and connected to the source electrode; and
a drain bus line spaced apart from the source bus line,
wherein each of the source bus line and the drain bus line includes:
a body portion extending in the second direction, and
a plurality of protrusion parts protruding from the body portion in the first direction, each having a width reduced as the protrusion part is further away from the body portion.

2. The semiconductor device of claim 1, wherein:
the plurality of protrusion parts of the source bus line are interleaved and alternately disposed with the plurality of protrusion parts of the drain bus line in the second direction.

3. The semiconductor device of claim 1 or claim 2, wherein:
each of the source bus line and the drain bus line includes concave parts disposed between the protrusion parts adjacent to each other,
the protrusion parts of the source bus line and the concave parts of the drain bus line face each other, and
the concave parts of the source bus line and the protrusion parts of the drain bus line face each other.

4. The semiconductor device of claim 3, wherein:
a first protrusion part of the plurality of protrusion parts of the source bus line overlaps the source electrode, and
a first protrusion part of the plurality of protrusion parts of the drain bus line overlaps the drain electrode.

5. The semiconductor device of claim 4, wherein:
a first concave part of the concave parts of the source bus line overlaps the drain electrode, and
a first concave part of the concave parts of the drain bus line overlaps the source electrode.

6. The semiconductor device of any of claims 3-5, wherein:
each of the protrusion parts and concave parts of the source bus line and the protrusion parts and concave parts of the drain bus line includes a curved surface.

7. The semiconductor device of claim 6, wherein:
a space between the source bus line and the drain bus line has a wave shape with a constant width.

8. The semiconductor device of any of claims 3-5, wherein:
each of the protrusion parts of the source bus line and the protrusion parts of the drain bus line has a triangular shape or a trapezoidal shape in a plan view.

9. The semiconductor device of any preceding claim, further comprising:
a source bonding connector connected to the source bus line,
wherein the source bonding connector overlaps a first protrusion part of the plurality of protrusion parts of the source bus line in the first direction.

10. The semiconductor device of claim 9, wherein:
the source bonding connector is in contact with an upper surface of the source bus line and is connected to a bonding wire.

11. The semiconductor device of claim 9 or claim 10, wherein:
the source bonding connector overlaps the body portion of the source bus line, and is disposed between one edge of the source bus line and a protrusion part of the source bus line.

12. The semiconductor device of any of claims 9-11, wherein:
at least a portion of the source bonding connector overlaps a protrusion part of the source bus line when viewed from a plan view.

13. The semiconductor device of any of claims 9-12, further comprising:
a drain bonding connector connected to the drain bus line,
wherein the drain bonding connector overlaps a first protrusion part of the plurality of protrusion parts of the drain bus line in the first direction.

14. The semiconductor device of any preceding claim, further comprising:
an interlayer insulating layer disposed on the source electrode and the drain electrode,
wherein:
the interlayer insulating layer includes a first opening overlapping the source electrode and a second opening overlapping the drain electrode,
the source bus line is connected to the source electrode by a source via disposed in the first opening, and
the drain bus line is connected to the drain electrode by a drain via disposed in the second opening.

15. The semiconductor device of claim 14, when dependent on claim 13, wherein:
the source bonding connector overlaps the first opening, and the drain bonding connector overlaps the second opening.
